# EUROPÄISCHE PATENTSCHRIFT

(11) **EP 0 414 052 B1**
(45) Veröffentlichungstag und Bekanntmachung des Hinweises auf die Patenterteilung: **09.06.1993**
(21) Anmeldenummer: 90115252.0
(22) Anmeldetag: 08.08.1990
(51) Int. Cl.: G01K 7/20, G01R 31/34

(54) **Anordnung zur Messung der Wicklungstemperatur von elektrischen Maschinen**
Device for measuring the temperature of the winding of electrical machinery
Agencement pour mesurer la température de l'enroulement d'une machine électrique

(30) Priorität: 22.08.1989 DE 3927698; 25.04.1990 DE 4013174
(43) Veröffentlichungstag der Anmeldung: 27.02.1991
(73) Patentinhaber: SIEMENS AKTIENGESELLSCHAFT, 80333 München (DE)
(72) Erfinder: Trenkler, Gerhard, Prof. Dr., D-2000 Hamburg-Barsbüttel (DE); Wedekind, Reinhard, Dipl.-Ing., D-2000 Hamburg 70 (DE); Maier, Reinhard, Dr., D-8522 Herzogenaurach (DE)

(56) Entgegenhaltungen:
- EP-A- 0 301 358
- DE-A- 1 766 949
- DE-C- 927 345
- FR-A- 1 231 721
- US-A- 4 741 023
- CONFERENCE PAPER OF THE IEEE POWER ENGINEERING SOCIETY, 31. Januar - 5. Februar 1971, Seiten 1-8; G.S. HOPE: "Machine identification using fast fourier transform"
- R. MÄUSL: "Modulationsverfahren in der Nachrichtentechnik", 1976, Kapital 1.3, Seiten 35-55, UTB Hüthig Verlag, Heidelberg, DE

## Beschreibung

Die Erfindung betrifft eine Anordnung zur Messung der Wicklungstemperatur von elektrischen Maschinen mittels einer Meß- und Verarbeitungsanordnung.

Es sind Anordnungen bekannt, die zur Temperaturerfassung einen oder mehrere Sensoren in oder an der Maschine verwenden (G. Müller, Elektrische Maschinen, Verlag Technik, Berlin 1974). Weiterhin sind Anordnungen bekannt, mit denen eine direkte Widerstandsmessung mit Gleichstrom durchgeführt wird (IEC Publikation 279, Measurement of the winding resistance of an a. c. machine during operation at alternating voltage, Genf, 1969). Erstere erfordern Temperatursensoren und die erforderlichen Zuleitungen, also erhöhten technischen Aufwand, letztere können fehlerhafte Messungen liefern. Gleichspannungspotentiale auf dem Netz, verursacht etwa durch im Betrieb befindliche Umrichter oder durch Thermospannungen, verursacht durch Löt-, Schweiß- oder Klemmstellen im Netz, die unterschiedliche Temperaturen aufweisen, können die Messung stark verfälschen. Die Möglichkeit, Gleichspannungspotentiale vom Netz mittels Kondensatoren abzublocken, ist nur bei kleinen Maschinen sinnvoll. Bei großen Maschinen wird der Kosten- und Platzaufwand für die Kondensatoren unverhältnismäßig groß.

Es ist auch bereits ein Verfahren bekannt (e & i, Jahrgang 105, Heft 7/8, Seiten 315 bis 318), das eine Rotortemperaturbestimmung von Käfigläufer-Asynchronmaschinen ohne thermischen Sensor ermöglicht. Hier wird aus dem Verlauf der Klemmenspannung nach Abschalten einer leerlaufenden Maschine und aus der Zeitkonstanten des Rotors auf dessen Temperatur geschlossen.

Aufgabe der Erfindung ist es, eine Anordnung zu schaffen, die unter Verzicht auf zusätzliche Sensoren eine Temperaturmessung über die Netzzuleitung der elektrischen Maschine im Betrieb ermöglicht. Weiterhin soll auf in Serie zur Maschine geschaltete Kondensatoren, über die die gesamte von der Maschine aufgenommene Leistung fließen müßte, verzichtet werden.

Die Aufgabe wird bei einer gattungsgemäßen Anordnung dadurch gelöst, daß dem die elektrische Maschine versorgenden Netz in einer oder mehreren Phasen jeweils eine oder mehrere Meßwechselspannungsquellen in Serie geschaltet werden so daß zur Netzspannung eine oder mehrere nicht netzfrequente, bekannte Spannungskomponenten addiert werden, die einen Strom mit diesen Frequenzen durch die Wicklung der Maschine erzeugen, der, mittels Stromwandler gemessen, ein Maß für den Leitwert der Wicklung und somit ein Maß für ihre Temperatur ist.

Die Meß- und Verarbeitungsanordnung ist in der Lage, während des Betriebes der Maschine den augenblicklichen Wicklungsleitwert zu erfassen. Aus dieser Größe ist bei bekannten Temperaturkoeffizienten des Wicklungsmaterials (im allgemeinen Kupfer: 0,004 l/K) und bekanntem Widerstand bei einer Bezugstemperatur die augenblickliche, mittlere Wicklungstemperatur ableitbar. Diese Wicklungstemperatur ist eine wichtige Kenngröße für den Betrieb einer Maschine. Die zulässige Höchsttemperatur soll einerseits aus Gründen der Lebensdauer nicht auf Dauer überschritten werden, andererseits soll aus Gründen der Wirtschaftlichkeit der Betrieb am Rande der Nenndaten erfolgen.

Als besonders vorteilhaft hat es sich erwiesen, wenn die Frequenzen des Stromes unter 10 Hz liegen. Um schädliche Einflüsse auf die Maschinentemperatur zu vermeiden, ist es vorteilhaft, wenn die Amplitude der Meßspannung im Hinblick auf die zusätzliche Erwärmung der Maschine durch die Meßspannung und damit auf die zulässige Maschinentemperatur gewählt ist. Hier hat es sich als vorteilhaft erwiesen, wenn die Amplitude 1 - 2 % der Amplitude der Netzwechselspannung beträgt.

Wird die Spannungsquelle als ein mit einer Spannung gespeister Resonzanzwandler ausgeführt, ist eine galvanische Entkopplung des Generators vom Netz zu erreichen. Wird die Spannungsquelle als ein mit einer Spannung gespeister Breitwandler ausgeführt, so ist zwar auch eine galvanische Entkopplung des Generators vom Netz zu erzielen. Auf den Kondensator, wie er beim Resonanzspannungswandler erforderlich ist, kann jedoch verzichtet werden und die verfügbare Bandbreite für das Meßsignal ist relativ groß. Auf den Wandler kann verzichtet werden, so daß die untere Frequenz frei gewählt werden kann, wenn die Spannungsquelle in einem Pulsumrichter integriert ist, in dem die Meßspannung durch zusätzliche Modulation mit der Meßfrequenz erzeugt wird. Wird die Spannungsquelle als eine mit der Meßfrequenz modulierte Gleichspannungsquelle ausgeführt, so ist ebenfalls kein Wandler erforderlich und die untere Grenzfrequenz kann frei gewählt werden. Diese Ausführung ist vorzuziehen, wenn kein Pulsumrichter vorhanden ist.

Wird die Spannungsquelle als ein Netzspannungsmodulator ausgeführt, kann das Meßsignal direkt aus dem versorgenden Netz gewonnen werden. Es können hierzu bekannte Anordnungen aus gesteuerten Wirk- oder Blindleitwerten sowie Schalter verwendet werden, wie sie beispielsweise aus dem Schriftsatz "Modulationsverfahren in der Nachrichtentechnik", R. Mäusl, UTB Hüthig Verlag, Heidelberg, 1976, Kap. 1.3, Seiten 35 - 55 bekannt sind. Da in diesem Fall Strom und Spannung gleichzeitig beeinflußt werden, ist für die Temperaturbestimmung die Messung beider Größen sowie die Bildung ihres Quotienten erforderlich.

Werden vom Netzspannungsmodulator Meßsignale aus mindestens drei unterschiedlichen Frequenzbereichen erzeugt, die getrennt ausgewertet werden, ist die Verwendung von multifrequenten Signalen, wie beispielsweise Rauschen, möglich.

Zusätzlich zu den angegebenen Ausführungsmöglichkeiten für die Messung und Auswertung hat sich die gleichzeitige Auswertung von Meßsignalen unterschiedlicher Frequenzen bzw. Frequenzbereichen zur differenzierten Möglichkeit zur Erkennung von deterministischen Störungen als vorteilhaft erwiesen. Da diese Störer schmalbandig sind und bekannte Frequenzdifferenzen aufweisen, können sie durch einfachen Amplitudenvergleich mehrerer Meßsignale unterschiedlicher Frequenz erkannt werden. Sind beispielsweise von mindestens drei Meßsignalen innerhalb der Meßunsicherheit zwei gleich und daher auswertbar, ist das dritte zu verwerfen.

Bei den Ausführungsformen für den Stromwandler gibt es ebenfalls mehrere Ausführungsmöglichkeiten. Wird der Stromwandler als Resonanzwandler ausgeführt, so sind neben der galvanischen Trennung vom Netz netzfrequente Signale wirksam bedämpft. Es ist jedoch zusätzlich ein Kondensator erforderlich. Wird der Stromwandler als Breitbandwandler ausgeführt, so ist hier ebenfalls, wie beim Resonanzwandler, eine galvanische Trennung vom Netz vorhanden. Der Kondensator ist hier entbehrlich und die verfügbare Bandbreite ist groß. Die wirtschaftlichste Möglichkeit, das Stromsignal zu gewinnen, besteht darin, daß der Stromwandler als Strommeßwiderstand ausgeführt ist. Auf den Stromwandler kann hier verzichtet werden, jedoch muß auf die galvanische Trennung verzichtet werden.

Eine einfache Ausführung für die Messung mit Auswertung erfolgt mittels selektiver Amplitudenmessung.

Erfolgt die Messung und Auswertung mittels Spektralanalyse, vorzugsweise durch Anwendung der Fast-Fourier-Transformation, können Störfrequenzen identifiziert werden und die Frequenzauflösung kann hoch sein. Erfolgt die Messung und Auswertung des Stromsignals mittels von der Spannungsquelle gesteuerter Synchrondemodulation, so ist Selektivität und Störminderung gegenüber stochastischen Störungen erzielbar. Ist die Spannungsquelle mittels eines Bandspreizungsfunktionsgenerators moduliert und das breitbandige Meßsignal einem Synchronmodulator für das Stromsignal zugeführt, so ist eine Störminderung gegenüber deterministischen Störungen erzielbar. Zusätzliche Maschinenfehler können ohne weiteren großen Aufwand erkannt werden, wenn in Mehrphasennetzen in jeder Phase eine Einrichtung zur Spannungseinspeisung und Strommessung vorhanden ist, denen eine Einrichtung zur Überwachung der Symmetrie der Signale zur Wicklungs- und/oder Körperschlußerkennung nachgeschaltet ist.

Mit geringem Mehraufwand kann auch die Drehzahl der Maschine ermittelt werden, wenn der Meßspannungsquelle eine Einrichtung zugeschaltet ist, durch die aus einer in eine Asynchronmaschine eingespeisten Wechselspannung ein der Drehzahl der Maschine proportionales Signal ableitbar ist, das an den Klemmen der Maschine als Spannungs- und/oder Stromsignal nachweisbar ist.

Die Erfindung wird anhand der Zeichnungen naher erläutert. Es zeigen:
- FIG 1: den grundsätzlichen Aufbau einer einphasigen Ausführung,
- FIG 2: eine prinzipielle Ausführung der Spannungsquelle.
- FIG 3: den grundsätzlichen Aufbau einer einphasigen Ausführung mit einer zusätzlichen Einrichtung zur Drehzahlmessung.

Vor der Beschreibung der Ausführungsmöglichkeiten der Funktionsstufen folgt zunächst die Beschreibung des gemeinsamen Prinzips anhand des Beispiels der elektrischen Asynchronmaschine.

Aus der Betrachtung des bekannten Ersatzschaltbildes dieser Maschine (T.Bödefeld, H.Sequenz: "Elektrische Maschinen", Springer-Verlag, 1949, 4. Auflage, Seite 159) erkennt man, daß nur bei der Frequenz Null der Ständerwiderstand direkt exakt gemessen werden kann. Bei der Netzfrequenz ergibt sich ein Realteil der Eingangsimpedanz, der eine große Abhängigkeit von Läuferwiderstand und vom Schlupf, also von der Belastung der Maschine aufweist. Es besteht jedoch die Möglichkeit, die Messung bei so niedrigen Frequenzen durchzuführen, bei denen Streueffekte und Transformationen von der Läuferseite in den Ständerkreis praktisch vernachlässigt werden können.

Die obere Grenzfrequenz, bei der eine nahezu lastunabhängige Messung möglich ist, ist abhängig vom Maschinentyp. Sie liegt vorteilhafterweise im Bereich unter 10 Hz.

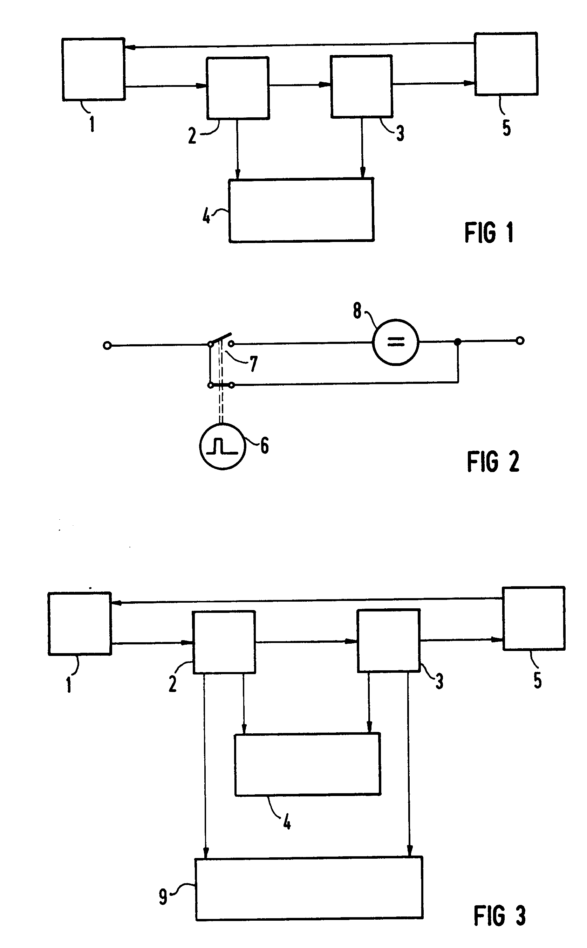

Bei dem Ausführungsbeispiel nach FIG 1 ist dem die Maschine 5 versorgenden Netz 1 eine geeignete Meßspannungsquelle 2 in Serie geschaltet, so daß diese bekannte niederfrequente Spannung zur Netzspannung geometrisch addiert wird und über die Wicklung der Maschine 5 und das Netz 1 ein Strom dieser Frequenz getrieben wird. Dieser Strom wird mit einem Stromwandler 3 erfaßt und einer Meß- und Auswerteeinrichtung 4 zugeführt. Die Amplitude der Meßspannung ist so zu wählen, daß keine nennenswerte zusätzliche Erwärmung der Maschine erfolgt, also beispielsweise 1 - 2 % der Netzspannung nicht überschreitet. Bei rotierenden elektrischen Maschinen treten in diesem Fall auch keine störenden Momente auf. Der Strom ist bei bekannter, konstanter Meßspannung dem zu messenden Leitwert proportional und kann direkt ausgewertet werden. Ist die Forderung nach konstanter Meßspannung nicht erfüllt, ist diese Spannung ebenfalls zu messen. Durch Quotientenbildung mittels, analoger oder digitaler Baugruppen kann dann der Leitwert oder der Widerstand bestimmt werden. Derartige Baugruppen sind beispielsweise aus Tietze, Schenk, Halbleiterschaltungstechnik, Springer-Verlag Berlin, 1986, 8. Auflage, Seite 344, bekannt. Der genannte Widerstand ist die Serienschaltung von Wicklungs- und Netzwiderstand. Letzterer kann aber vernachlässigt werden, wenn er um einige Größenanordnungen kleiner ist als der Wicklungswiderstand. Diese Forderung ist in üblichen Netzen erfüllt. Soll zur Erhöhung der Genauigkeit der Netzwiderstand mit in die Messung einbezogen werden, so ist er zu messen und in der Auswertung durch einfache Subtraktion zu berücksichtigen, da er im praktischen Fall konstant ist.

Für die in FIG 1 dargestellten Funktionsstufen 2, 3 und 4 sind mehrere Ausführungsmöglichkeiten gegeben. Aufwand und Leistung sind unterschiedlich, so daß eine der Meßaufgabe angepaßte optimale Kombination gewählt werden kann.

Ausführungsmöglichkeiten für die Meßspannungsquelle:

### 1. Ausführung mit Resonanzspannungswandler

Die Meßspannungsquelle, beispielsweise ein einfacher Funktionsgenerator, speist einen Resonanzwandler, der mittels eines Kondensators vorzugsweise in Serienresonanz betrieben wird. Auf diese Weise werden netzfrequente Rückwirkungen auf den Funktionsgenerator wirksam vermieden. Die Anforderungen an den Funktionsgenerator sind gering, sein Quellwiderstand sollte die Güte des Resonanzkreises nicht wesentlich beeinträchtigen. Von Vorteil ist die galvanische Entkopplung des Generators vom Netz.

Der Resonanzwandler ist auf die feste Meßfrequenz abzustimmen, die sicher oberhalb seiner durch den Übertrager gegebenen unteren Grenzfrequenz liegen muß. Die Anforderungen an die Frequenzstabilität sind hoch, da sonst Amplituden- und Phasenfehler auftreten können.

### 2 Ausführung mit Breitbandspannungswandler

Auch hier ist die galvanische Entkopplung des Generators vom Netz von Vorteil. Auf einen Kondensator kann verzichtet werden. Die verfügbare Bandbreite für das Meßsignal ist groß. Der Quellwiderstand des speisenden Generators muß sehr niedrig sein und das Übersetzungsverhältnis des Übertragers darf nicht zu gering sein, da sonst die zur Generatorseite herübertransformierten netzfrequenten Spannungen am Quellwiderstand des Generators nicht hinreichend abfallen und ihn gefährden könnten.

### 3 Verwendung eines Pulsumrichters

Wird die elektrische Maschine an einem Pulsumrichter betrieben, kann der vorhandene Modulator dazu eingesetzt werden, durch zusätzliche Modulation mit der gewünschten Meßfrequenz, die gewünschte Meßspannung zu erzeugen. Es ist also kein Wandler erforderlich, die untere Grenzfrequenz kann frei gewählt werden.

Zu beachten ist jedoch, daß insbesondere bei niedrigen Betriebsfrequenzen mögliche Störspannungen im Frequenzbereich der Meßspannung vorhanden sind. In diesem Fall ist ein ausreichender Störabstand zu sichern. Möglichkeiten hierzu werden in der noch folgenden Beschreibung zur Messung und Auswertung angegeben.

### 4 Ausführung als modulierte Gleichspannungsquelle

In FIG 2 ist eine diesbezügliche prinzipielle Ausführung dargestellt. Ein Umschalter 7 wird durch einen Pulsgenerator 6 gesteuert und schaltet die Gleichspannungsquelle 8 kurzzeitig in Serie zum Netz. Der Umschalter 7 ist vorteilhafterweise eine bekannte Anordnung von Halbleiterschaltern. Der Pulsgenerator 6 betätigt diesen Schalter mit der Meßfrequenz. Es erfolgt so eine Modulation der von der Gleichspannungsquelle 8 gelieferten Gleichspannung mit der Meßfrequenz und gleichzeitig eine Addition des Modulationsproduktes zur Netzspannung. Der Effektivwert der Meßspannung kann über die Gleichspannung und/oder über die Pulsbreite des Steuersignals des Pulsgenerators 6 bestimmt werden. Im Ausgang der Gleichspannungsquelle 8 ist üblicherweise ein Siebkondensator vorhanden, der kurzzeitig für die Dauer des Pulses in Serie zur Maschine und zum Netz geschaltet wird. Über ihn fließt nur für die Dauer des Steuersignals des Pulsgeneratos Strom und somit nur ein vernachlässigbarer Teil der Maschinenleistung. Durch geeignete Wahl der Steuerzeiten kann der Aufwand für diesen Kondensator minimiert werden. Die untere Grenzfrequenz des Meßsignals ist bei dieser Anordnung ebenfalls frei wählbar. Es erfolgt jedoch bei Verwendung von Halbleiterschaltern für den Umschalter 7 keine galvanische Entkopplung vom Netz. Ebenfalls liegt die Gleichspannungsquelle 8 auf Netzpotential. Es ist daher erforderlich; die Versorgungen für den Pulsgenerator 6 und die Gleichspannungsquelle 8 so zu gestalten, daß die erforderliche Potentialtrennung gewährleistet ist.

Der in FIG 1 benutzte Stromwandler 3 kann als Resonanzstromwandler ausgeführt werden. Hierzu wird ein Stromwandler mittels eines Kondensators in Parallelresonanz auf der festen Meßfrequenz betrieben. In seinem Ausgangssignal sind daher netzfrequente Signale wirksam bedämpft, so daß die Weiterverarbeitung vereinfacht wird. Von weiterem Vorteil ist die galvanische Trennung vom Netz. Die Meßfrequenz muß sicher oberhalb der unteren Grenzfrequenz des Wandlers liegen, die Anforderungen an die Frequenzstabilität sind hoch, da sonst Amplituden- und Phasenfehler auftreten können.

Bei einer Ausführung des Stromwandlers 3 als Breitbandstromwandler wird ein einfacher Stromwandler verwendet, dessen untere Grenzfrequenz unterhalb der Meßfrequenz liegt. Auf einen Kondensator kann hier verzichtet werden. Die verfügbare Bandbreite ist groß. Von weiteren Vorteil ist die galvanische Trennung des Ausgangssignals vom Netzpotential. Netzfrequente Ausgangssignale müssen in der Auswertungseinrichtung durch übliche Tiefpaßfilter hinreichend bedämpft werden.

Die wirtschaftlichste Möglichkeit, das Stromsignal zu gewinnen, besteht in der Verwendung eines einfachen Strommeßwiderstands. Auf einem Stromwandler kann verzichtet werden, eine untere Grenzfrequenz ist nicht vorhanden. Der Strommeßwiderstand geht in das Meßergebnis ein. Er ist daher so zu dimensionieren, daß sein Einfluß vernachlässigbar ist. Falls dies nicht möglich ist, kann er in der Auswertung durch einfache Subtraktion berücksichtigt werden, da sein Wert bekannt ist. Eine galvanische Trennung vom Netzpotential ist bei dieser Ausführung nicht vorhanden.

Für die Messung und Auswertung 4 bestehen beispielsweise folgen de Ausführungsmöglichkeiten:

### 1. Selektive Amplitudenmessung

Die Meßspannung und/oder der -strom werden mittels auf die Meßfrequenz abgestimmter selektiver Filter gewonnen und einem bekannten Mittelwertbildner zugeführt. Der Mittelwert wird in üblicher Weise bestimmt und, wie vorstehend beschrieben, in die Wicklungstemperatur umgerechnet. Für diese einfache Anordnung ist ein ausreichender Störabstand zwischen Nutz- und Störsignalen erforderlich. Er kann durch hohe Güte der selektiven Filter und/oder große Zeitkonstanten des Mittelwertbildners verbessert werden. Die Erfassungszeit für Temperaturänderungen steigt in diesem Fall.

### 2. Spektralanalyse

Die Meßspannung und/oder der Meßstrom werden mit einem handelsüblichen Spektrumanalysator ausgewertet. Störfrequenzen können identifiziert werden und die Frequenzauflösung kann bei Bedarf sehr hoch sein. Es können bekannte analoge Analysatoren oder vorzugsweise digitale Fast-Fourier-Transformations-Analysatoren verwendet werden.

### 3. Synchrondemodulation

Frequenz und Phase der eingespeisten Spannung sind gegeben, daher besteht die Möglichkeit, das Stromsignal mittels Synchrongleichrichtung zu gewinnen. Mit dieser Methode ist Selektivität und Störminderung gegenüber stochastischen Störungen erzielbar. Synchrondemodulationen sind beispielsweise aus Tietze, Schenk, Halbleiterschaltungstechnik, Springer-Verlag Berlin, 1986, 8. Auflage, Seite 797 ff, bekannt.

### 4. Bandspreizung

Werden Breitbandwandler verwendet, kann die Spannungsquelle mit einer geeigneten Bandspreizfunktion moduliert werden. Als Modulationsverfahren kommen beispielsweise Frequenz- oder Phasensprungmodulation in Frage. Das modulierte Signal wird als Referenz zur synchronen Demodulation des Stromsignals verwendet. Mit einer solchen Anordnung ist Störminderung gegenüber deterministischen Störungen erzielbar. Derartige Verfahren sind aus Baier, Grünberger, Pandit, Störunterdrückende Funkübertragungstechnik, R. Oldenburg Verlag, München, 1984, Seite 90 ff bekannt.

Wird in Mehrphasennetzen in jeder Phase Spannungseinspeisung und Strommessung durchgeführt, so kann durch Überwachung der Symmetrie der Signale zusätzliche Information über den Betriebszustand der elektrischen Maschine gewonnen werden. Im Betrieb auftretende Störungen, wie beispielsweise Wicklungs- und/oder Körperschluß, können so detektiert werden.

In der erfindungsgemäßen Anordnung können außerdem Frequenzkomponenten erzeugt werden, die auf der Modulation der Meßwechselspannung beruhen. Da sie proportional zur Drehzahl sind, können sie zur Drehzahlmessung verwendet werden. Durch geeignete Wahl der Frequenz der Meßwechselspannung können die Modulationsprodukte in einen störungsfreien Frequenzbereich umgesetzt werden, so daß eine einfache Auswertung möglich ist.

Bei dem Ausführungsbeispiel nach FIG 3 ist dem die Maschine 5 versorgenden Netz 1 eine Meßspannungsquelle 2 in Serie geschaltet, die eine zusätzliche, vorteilhafterweise von der Temperaturmeßfrequenz verschiedene, nicht netzfrequente Spannung liefert. Der Wandler 3 liefert ein Strom- und/oder Spannungssignal, in dem drehzahlproportionale Frequenzkomponenten enthalten sind. Die Meßspannungsquelle 2 und der Wandler 3 sind für den Fall unterschiedlicher Meßfrequenzen nicht als Resonanzwandler auszuführen. Baugruppen zur Messung und Auswertung 9 sind bekannt.

Es sind bereits Verfahren und Anordnungen zur Drehzahlerfassung elektrischer Induktionsmaschinen vorgeschlagen (P 37 11 976.1; P 37 34 071.9), die drehzahlproportionale Frequenzkomponenten, die in Strom und/oder Spannung nachweisbar sind, auswerten. Diese Verfahren werten drehzahlabhängige Modulationsprodukte der Netzfrequenz aus.

## Patentansprüche

1. Anordnung zur Messung der Wicklungstemperatur von elektrischen Maschinen (5) mittels einer Meß- und Verarbeitungsanordnung, **dadurch gekennzeichnet,** daß dem die elektrische Maschine versorgenden Netz (1) in einer oder mehreren Phasen jeweils eine oder mehrere Meßwechselspannungsquellen (2) in Serie geschaltet werden, so daß zur Netzspannung eine oder mehrere nicht netzfrequente, bekannte Spannungskomponenten addiert werden, die einen Strom mit diesen Frequenzen durch die Wicklung der Maschine erzeugen, der, mittels Stromwandler (3) gemessen, ein Maß für den Leitwert der Wicklung und somit ein Maß für ihre Temperatur ist.

2. Anordnung nach Anspruch 1, **dadurch gekennzeichnet,** daß die Frequenzen des Stromes unter 10 Hz liegen.

3. Anordnung nach Anspruch 1 oder 2, **dadurch gekennzeichnet,** daß die Amplitude der Meßspannung im Hinblick auf die zusätzliche Erwärmung der Maschine durch die Meßspannung und damit auf die zulässige Maschinentemperatur gewählt ist.

4. Anordnung nach Anspruch 3, **dadurch gekennzeichnet,** daß die Amplitude 1 - 2 % der Amplitude der Netzwertspannung beträgt.

5. Anordnung nach Anspruch 1, **dadurch gekennzeichnet,** daß die Spannungsquelle (2) als ein mit einer Spannung gespeister Resonanzwandler ausgeführt ist.

6. Anordnung nach Anspruch 1, **dadurch gekennzeichnet,** daß die Spannungsquelle (2) als ein mit einer Spannung gespeister Breitbandwandler ausgeführt ist.

7. Anordnung nach Anspruch 1, **dadurch gekennzeichnet,** daß die Spannungsquelle (2) mit einem Pulsumrichter integriert ist, in dem die Meßspannung durch zusätzliche Modulation mit der Meßfrequenz erzeugt wird.

8. Anordnung nach Anspruch 1, **dadurch gekennzeichnet,** daß die Spannungsquelle (2) als eine mit der Meßfrequenz modulierte Gleichspannungsquelle ausgeführt ist. (FIG 2)

9. Anordnung nach Anspruch 1, **dadurch gekennzeichnet,** daß die Spannungsquelle (2) als ein Netzspannungsmodulator ausgeführt ist.

10. Anordnung nach Anspruch 9, **dadurch gekennzeichnet,** daß vom Netzspannungsmodulator Meßsignale aus mindestens drei unterschiedlichen Frequenzbereichen erzeugt werden, die getrennt ausgewertet werden.

11. Anordnung nach einem der Ansprüche 1 bis 8, **dadurch gekennzeichnet,** daß der Stromwandler (3) als Resonanzwandler ausgeführt ist.

12. Anordnung nach einem der Ansprüche 1 bis 8, **dadurch gekennzeichnet,** daß der Stromwandler (3) als Breitbandwandler ausgeführt ist.

13. Anordnung nach einem der Ansprüche 1 bis 8, **dadurch gekennzeichnet,** daß der Stromwandler (3) als Strommeßwiderstand ausgeführt ist.

14. Anordnung nach einem der Ansprüche 1 bis 11, **dadurch gekennzeichnet,** daß die Messung und Auswertung (4) mittels selektiver Amplitudenmessung erfolgt.

15. Anordnung nach einem der Ansprüche 1 bis 14, **dadurch gekennzeichnet,** daß die Messung und Auswertung (4) mittels Spektralanalyse, vorzugsweise durch Anwendung der Fast-Fourier-Transformation erfolgt.

16. Anordnung nach einem der Ansprüche 1 bis 11, **dadurch gekennzeichnet,** daß die Messung und Auswertung (4) des Stromsignals mittels von der Spannungsquelle (2) gesteuerter Synchrondemodulation erfolgt.

17. Anordnung nach einem der Ansprüche 1 bis 14, **dadurch gekennzeichnet,** daß die Spannungsquelle (2) mittels eines Bandspreizfunktionsgenerators moduliert ist und das breitbandige Meßsignal einem Synchrondemodulator für das Stromsignal zugeführt wird.

18. Anordnung nach Anspruch 1 bis 15, **dadurch gekennzeichnet,** daß in Mehrphasennetzen in jeder Phase eine Einrichtung zur Spannungseinspeisung und Strommessung vorhanden ist, denen eine Einrichtung zur Überwachung der Symmetrie der Signale zur Wicklungs- und/oder Körperschlußerkennung nachgeschaltet ist.

19. Anordnung nach einem der Ansprüche 1 bis 16, **dadurch gekennzeichnet,** daß der Meßspannungsquelle (2) eine Einrichtung zugeschaltet ist, durch die aus einer in eine Asynchronmaschine eingespeisten Meßwechselspannung ein der Drehzahl der Maschine proportionales Signal ableitbar ist, das an den Klemmen der Maschine als Spannungs- und/oder Stromsignal nachweisbar ist.

## Claims

1. Arrangement for measuring the temperature of the winding of electrical machines (5) by means of a measuring and processing arrangement, characterized in that in one or more phases, in each case, one or more measuring alternating-voltage sources (2) are connected in series with the supply system (1) supplying the electrical machine, so that one or more known voltage components which are not at system frequency are added to the system voltage, which voltage components generate a current with these frequencies through the winding of the machine, which, measured by means of current transformers (3), is a measure of the conductance of the winding and thus a measure of its temperature.

2. Arrangement according to claim 1, characterized in that the frequencies of the current lie below 10 Hz.

3. Arrangement according to claim 1 or 2, characterized in that the amplitude of the measuring voltage is chosen with regard to the additional heating of the machine by means of the measuring voltage and thus with regard to the permissible machine temperature.

4. Arrangement according to claim 3, characterized in that the amplitude amounts to 1 - 2 % of the amplitude of the system value voltage.

5. Arrangement according to claim 1, characterized in that the voltage source (2) is designed as a resonance transformer supplied with a voltage.

6. Arrangement according to claim 1, characterized in that the voltage source (2) is designed as a wide-band transformer supplied with a voltage.

7. Arrangement according to claim 1, characterized in that the voltage source (2) is integrated with a pulse converter in which the measuring voltage is generated by additional modulation with the measuring frequency.

8. Arrangement according to claim 1, characterized in that the voltage source (2) is designed as a direct-voltage source modulated with the measuring frequency. (Figure 2)

9. Arrangement according to claim 1, characterized in that the voltage source (2) is designed as a system voltage modulator.

10. Arrangement according to claim 9, characterized in that measuring signals consisting of at least three different frequency ranges are generated by the system voltage modulator, the signals being evaluated separately.

11. Arrangement according to any one of claims 1 to 8, characterized in that the current transformer (3) is designed as a resonance transformer.

12. Arrangement according to any one of claims 1 to 8, characterized in that the current transformer (3) is designed as a wide-band transformer.

13. Arrangement according to any one of claims 1 to 8, characterized in that the current transformer (3) is designed as a current measuring resistance.

14. Arrangement according to any one of claims 1 to 11, characterized in that the measurement and evaluation (4) takes place by means of selective amplitude measurement.

15. Arrangement according to any one of claims 1 to 14, characterized in that the measurement and evaluation (4) takes place by means of spectral analysis, preferably through the use of fast Fourier Transformation.

16. Arrangement according to any one of claims 1 to 11, characterized in that the measurement and evaluation (4) of the current signal takes place by means of synchronous demodulation controlled by the voltage source (2).

17. Arrangement according to one of claims 1 to 14, characterized in that the voltage source (2) is modulated by means of a band spread function generator and the wide-band measuring signal is supplied to a synchronous demodulator for the current signal.

18. Arrangement according to claim 1 to 15, characterized in that in multiphase systems in each phase a device for feeding in voltage and for current measurement is present, with which there is connected in series a device for monitoring the symmetry of the signals for recognizing winding-to-frame and/or frame short circuit.

19. Arrangement according to any one of claims 1 to 16, characterized in that a device is connected to the measuring voltage source (2), by means of which, from a measuring alternating voltage fed into an asynchronous machine, a signal proportional to the speed of the machine can be derived, which can be detected at the terminals of the machine as voltage signal and/or current signal.

## Revendications

1. Dispositif pour mesurer la température de l'enroulement de machines électriques (5) au moyen d'un dispositif de mesure et de traitement, caractérisé par le fait qu'en série avec le réseau (1), qui alimente la machine électrique, sont branchées en série, dans une ou plusieurs phases, respectivement une ou plusieurs sources de tension alternative de mesure (2), de sorte qu'à la tension du réseau sont ajoutées une ou plusieurs composantes de tension à basse fréquence connues, qui produisent dans l'enroulement de la machine un courant qui possède ces fréquences et qui, mesuré au moyen d'un transformateur d'intensité (3), est une mesure de la conductivité de l'enroulement et par conséquent une mesure de sa température.

2. Dispositif suivant la revendication 1, caractérisé par le fait que les fréquences du courant sont inférieures à 10 Hz.

3. Dispositif suivant la revendication 1 ou 2, caractérisé par le fait que l'amplitude de la tension de mesure est choisie en fonction de l'échauffement supplémentaire de la machine par la tension de mesure et, par conséquent, en fonction de la température admissible de la machine.

4. Montage suivant la revendication 3, caractérisé par le fait que l'amplitude est égale à 1-2 % de l'amplitude de la tension du réseau.

5. Dispositif suivant la revendication 1, caractérisé par le fait que la source de tension (2) est réalisée sous la forme d'un transducteur à résonance alimenté par une tension.

6. Dispositif suivant la revendication 1, caractérisé par le fait que la source de tension (2) est réalisée sous la forme d'un convertisseur à large bande, alimenté par une tension.

7. Dispositif suivant la revendication 1, caractérisé par le fait que la source de tension est intégrée dans un convertisseur d'impulsions, dans lequel la tension de mesure est produite par une modulation supplémentaire avec la fréquence de mesure.

8. Dispositif suivant la revendication 1, caractérisé par le fait que la source de tension (2) est réalisée sous la forme d'une source de tension continue modulée par la fréquence de mesure. (Figure 2).

9. Dispositif suivant la revendication 1, caractérisé par le fait que la source de tension (2) est réalisée sous la forme d'un modulateur de la tension du réseau.

10. Dispositif suivant la revendication 9, caractérisé par le fait que le modulateur de la tension du réseau produit des signaux de mesure à partir d'au moins trois gammes de fréquences différentes, qui sont évaluées séparément.

11. Dispositif suivant l'une des revendications 1 à 8, caractérisé par le fait que le transformateur d'intensité (3) est réalisé sous la forme d'un convertisseur à résonance.

12. Dispositif suivant l'une des revendications 1 à 8, caractérisé par le fait que le transformateur d'intensité (3) est réalisé sous la forme d'un convertisseur à large bande.

13. Dispositif suivant l'une des revendications 1 à 8, caractérisé par le fait que le transformateur d'intensité (30) est réalisé sous la forme d'une résistance ampèremétrique.

14. Dispositif suivant l'une des revendications 1 à 11, caractérisé par le fait que la mesure et l'évaluation (4) sont réalisées au moyen d'une mesure sélective d'amplitudes.

15. Dispositif suivant l'une des revendications 1 à 14, caractérisé par le fait que la mesure et l'évaluation (4) sont réalisées au moyen d'une analyse spectrale, de préférence moyennant l'utilisation de la transformation de Fourier rapide.

16. Dispositif suivant l'une des revendications 1 à 11, caractérisé par le fait que la mesure et l'évaluation (4) du signal de courant sont réalisées au moyen d'une démodulation synchrone commandée par la source de tension (2).

17. Dispositif suivant l'une des revendications 1 à 14, caractérisé par le fait que la source de tension (2) est modulée au moyen d'un générateur de fonction d'étalement de bande et que le signal de mesure à large bande est envoyé à un démodulateur synchrone pour le signal de courant.

18. Dispositif suivant l'une des revendications 1 à 15, caractérisé par le fait que dans des réseaux polyphasés il est prévu, dans chaque phase, un dispositif pour réaliser l'alimentation en tension et l'alimentation en courant, en aval duquel est branché un dispositif pour contrôler la symétrie des signaux pour l'identification d'un court-circuit de l'enroulement et/ou d'un circuit à la masse.

19. Dispositif suivant l'une des revendications 1 à 7, caractérisé par le fait qu'en supplément de la source de tension de mesure (2) est branché un dispositif grâce auquel on peut obtenir, à partir d'une tension alternative de mesure introduite dans une machine asynchrone, un signal proportionnel à la vitesse de rotation de la machine et qui peut être détecté au niveau des bornes de la machine en tant que signal de tension et/ou signal de courant.
